## Europäisches Patentamt
## European Patent Office
## Office européen des brevets

(19)

(11) Veröffentlichungsnummer: **0 215 810**
**B1**

# EUROPÄISCHE PATENTSCHRIFT

(45) Veröffentlichungstag der Patentschrifft:
**07.02.90**

(21) Anmeldenummer: **86900994.4**

(22) Anmeldetag: **20.12.85**

(86) Internationale Anmeldenummer:
**PCT/EP 85/00729**

(87) Internationale Veröffentlichungsnummer:
**WO 86/05594 (25.09.86 Gazette 86/21)**

(51) Int. Cl. ⁵: **G 01 R 19/22,** G 06 F 15/36

(54) SCHALTUNGSANORDNUNG ZUR MITTELWERTBILDUNG.

(30) Priorität: **19.03.85 DE 3509762**

(43) Veröffentlichungstag der Anmeldung:
**01.04.87 Patentblatt 87/14**

(45) Bekanntmachung des Hinweises auf die Patenterteilung:
**07.02.90 Patentblatt 90/06**

(84) Bennante Vertragsstaaten:
**AT BE CH DE FR GB IT LI LU NL SE**

(56) Entgegenhaltungen:
**DE-A-3 121 310
GB-A-1 523 729
GB-A-2 007 392**

(73) Patentinhaber: **Battelle-Institut e.V.
Am Römerhof 35 Postfach 900 160
D-6000 Frankfurt/Main 90 (DE)**

(72) Erfinder: **GERRATH, Karl-Heinz
Lindenstrasse 2
D-6103 Griesheim (DE)**

(74) Vertreter: **Sartorius, Peter, Dipl.-Ing.
Battelle-Institut e.V. Abteilung Patente Am Römerhof 35
D-6000 Frankfurt am Main 90 (DE)**

LIBERGRAF, STOCKHOLM 1990

# EP 0 215 810 B1

**Beschreibung**

Die Erfindung bezieht sich auf eine Schaltungsanordnung zur Mittelwertbildung eines aus rechteckigen Pulsen bestehenden Signals, nach dem Oberbegriff des Patentanspruches 1.

Die zeitliche Mittelwertbildung von aus Rechteckimpulsen bestehenden Signalen kann z. B. durch Integration über zumindest eine Periode des Rechtecksignals erfolgen oder auch über eine Tiefpaßfilterung. Die Integration kann über einen Aufwärts-Abwärts-Zähler durchgeführt werden. Nachteilig für einen Prozessor ist jedoch die dann notwendige Division durch die Periodendauer, die auch zeitlich relativ aufwendig sein kann.

Bei der Tiefpaßfilterung wird das zeitlich bestimmte Integral durch ein unbestimmtes Integral über den Bereich $-\infty \leq t \leq +\infty$ ersetzt. Entsprechend muß das Einschwingverhalten des Filters berücksichtigt werden, da sonst die Ergebnisse nicht genau sind.

Digitale Tiefpaßfilter stellen zeitliche periodische Netzwerke dar, bei denen sich Durchlaß- und Sperrbereiche nacheinander abwechseln. Da ein impulsförmiges Signal Spektralkomponenten über einen sehr weiten Frequenzbereich haben kann, ist eine sehr genaue Abstimmung des Tiefpasses hinsichtlich Taktfrequenz und Filterverlauf in bezug auf das Signal erforderlich. Der wesentliche Nachteil des Tiefpaßfilters besteht in der hohen zu realisierenden Sperrdämpfung.

Diese Probleme führen dazu, daß ein zu großer schaltungsmäßiger Aufwand bewältigt werden muß, um annehmbare Ergebnisse zu erzielen.

Bei einem bekannten Verfahren zur arithmetischen Mittelwertbildung (GB-A-1 523 729) werden mehrere Filterstufen in einer ganz bestimmten Weise hintereinander geschaltet. Dieses Filterverfahren ist bei gleichem Aufwand weniger exakt.

Bei einem weiteren Verfahren (GB-A-2 007 392) ist ein Prozessor eingesetzt, der zwei Filterverfahren beinhaltet, wobei das eine Filterverfahren eine gleitende Mittelwertbildung erstellt und das andere Filterverfahren eine arithmetische Mittelwertbildung beinhaltet, so daß die beiden getrennt nebeneinander bestehenden Verfahren nicht zu dem erfindungsgemäßen Ergebnis kommt.

Bei einem digitalen Filter der eingangs aufgeführten Art (DE-A-3 121 310), bei welchem N+1 Abtastwerte eines digitalen Signals zu einer Mittelwertbildung herangezogen werden, wird das digitale Signal N+1 Abtastperioden verzögert und vom unverzögerten Signal subtrahiert. Die Differenzwerte werden akkumuliert. Gegenüber der Mittelwertbildung mit einem N+1-Eingänge aufweisenden Addierer sollen sich Vereinfachungen ergeben. Jedoch stellt das bekannte Filter ein Filter im Frequenzbereich dar, d. h. die Nullstellen liegen bei bestimmten Frequenzen. Somit paßt sich das Filter nicht automatisch der Eingangsfrequenz der Impulse an (die Lage der Nullstellen wird durch die Zeitverschiebung $\tau$ bestimmt). Es wird durch dieses Verfahren der Aufwand wesentlich erhöht, zumal ein zusätzlicher Dividierer vorgesehen werden muß, mittels dem durch die Anzahl der akkumulierten Werte dividiert wird. Bei sich ändernder Periodendauer besteht darüber hinaus das Problem der genauen Bestimmung der Periodendauer durch Auszählen.

Der vorliegenden Erfindung liegt die Aufgabe zugrunde, ein im Vergleich zu bekannten Anordnungen mit geringem Aufwand realisierbares Filter zu entwickeln, bei dem das Verhältnis zwischen Taktfrequenz und Durchlaßbandbreite sehr groß ist und mit dem eine genaue Mittelwertbildung möglich ist.

Diese Aufgabe ist durch die in Anspruch 1 aufgeführten Merkmale gelöst.

Es kann das erfindungsgemäße Filter in seiner einfachsten Art durch die Beziehung

$$Y_n = Y_{n-1}(1-\alpha) + \alpha X_n$$

beschrieben werden. Dabei ist $X_n$ der Eingangswert zum Zeitpunkt $t_n$, $Y_n$ der generative Ausgangswert zum Zeitpunkt $t_n$, $Y_{n-1}$ der Ausgangswert zum vorhergehenden Zeitpunkt $t_{n-1}$ und $\alpha$ ein Faktor, der das Einschwingverhalten des Filters bestimmt. Die zusätzliche arithmetische Mittelwertbildung erfolgt erfindungsgemäß über eine Periodendauer oder ein Vielfaches der Periodendauer. Bei der erfindungsgemäßen Schaltungsanordnung wird die Mittelwertbildung über die Pulsfolge mit einer sehr hohen Genauigkeit bestimmt. Die Mittelwertbildung wird dabei in vorteilhafter Weise unabhängig von der Periodendauer gemacht. Die erfindungsgemäße Schaltungsanordnung ist deshalb so gewählt, daß eine genaue Kenntnis der Periodendauer nicht erforderlich ist. Es lassen sich deshalb in vorteilhafter Weise auch solche Signale verarbeiten, deren Periodendauer ständig schwankt. Ändert sich beispielsweise die Periodendauer fortlaufend, so ist das Auszählen der Signale nicht mehr erforderlich. Deshalb braucht bei fortlaufender Änderung der Periodendauer nicht mehr exakt zwischen den Flanken des Signals gemessen werden. Durch die erfindungsgemäße Schaltungsanordnung paßt sich die Mittelwertbildung (Tief-Pass-Verhalten) fortlaufend der Frequenz des Signals an, was zu einer wesentlichen Vereinfachung führt.

Vorteilhafte Ausgestaltungen der Erfindung gehen aus den abhängigen Ansprüchen hervor.

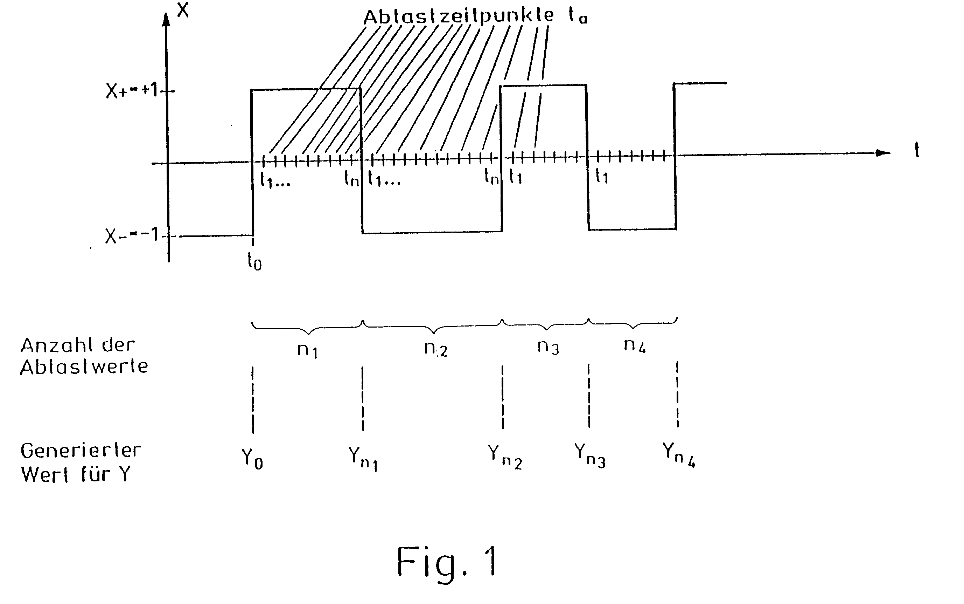

Bei einem aus Rechteckimpulsen bestehenden Signal wird angenommen, daß die Eingangsfunktion nur bestimmte Werte, z. B. $X_+ = +1$ und $X_- = -1$ annimmt (s. Fig. 1). Beträgt zum Zeitpunkt $t_0$ der Eingangswert $X = X_+$, so ergibt sich nach n-Schritten zum Zeitpunkt $t_n$ für $Y_n$

$$Y_n = Y_0(1-\alpha)^n + X_+ \cdot \alpha \sum_{m=0}^{n-1}(1-\alpha)^m$$

2

Hierbei ist $Y_0$ der Ausgangswert von Y zum Zeitpunkt $t_0$.

Diese Formel läßt sich wie folgt ableiten:

$$n = 1 \quad Y_1 = Y_0 (1-\alpha) + \alpha X_+$$
$$n = 2 \quad Y_2 = Y_1 (1-\alpha) + \alpha X_+$$
$$= Y_0 (1-\alpha)^2 + (\alpha + \alpha(1-\alpha)) \cdot X_+$$
$$n = 3 \quad Y_3 = Y_2 (1-\alpha) + \alpha \cdot X_+$$
$$= Y_0 (1-\alpha)^3 + (\alpha + \alpha(1-\alpha) + \alpha (1-\alpha)^2) \cdot X_+$$

usw.

$$Y_n = Y_0 (1-\alpha)^n + X_+ \cdot \alpha (1+(1-\alpha) + \dots (1-\alpha)^{n-1})$$

$$Y_n = Y_0 (1-\alpha)^n + X_+ \cdot \alpha \sum_{m=O}^{n-1} (1-\alpha)^m$$

Der Anteil $\alpha \sum\limits_{m=O}^{n-1} (1-\alpha)^m$ läßt sich mathematisch wie folgt vereinfachen:

$$\alpha \sum_{m=O}^{n-1} (1-\alpha)^m = 1 - (1-\alpha)^n$$

Diese Beziehung ergibt sich aus der Summenformel für Potenzreihen

$$\sum_{m=O}^{n} q^m = \frac{1 - q^{n+1}}{1 - q} \qquad \text{für } q \neq 1$$

durch Einsetzen von $q = 1 - \alpha$.

Beträgt die Anzahl der Abtastwerte während der Zeit, in der X den Wert $X_+$ annimmt, gerade $n_1$, so ist nach $n_1$ Werten $Y_{n1}$ erreicht. Danach beginnt ein neuer Zyklus, bei dem jetzt entsprechend der Amplitudenwert $X = X_-$ zu setzen ist.

Die Anzahl der Abtastwerte beträgt jetzt $n = n_2$, der Wert für Y am Ende dieses Zyklus ist dann $Y_{n2}$. Im folgenden Zyklus wird wiederum $x = X_+$. Die Anzahl der Abtastwerte beträgt $n = n_3$, der Wert für Y am Ende dieses Zyklus ist $Y_{n3}$.

Die Beziehungen für Y lassen sich damit beschreiben durch

$$Y_{n_1} = X_+ + (Y_0 - X_+) (1-\alpha)^{n_1}$$
$$Y_{n_2} = X_- + (Y_{n_1} - X_-) (1-\alpha)^{n_2}$$
$$Y_{n_3} = X_+ + (Y_{n_2} - X_+) (1-\alpha)^{n_3}$$

usw.

Damit ist die Berechnung der Ausgangswerte des Filters nur noch am Ende eines jeweiligen Zyklus, innerhalb dessen X, also die Amplitude, jeweils konstant bleibt, notwendig.

Für ein Eingangssignal mit konstantem Tastverhältnis läßt sich dies wie folgt darstellen:

Im eingeschwungenen Zustand des Filters betragen die jeweiligen Werte mit

$$n_1 = n_3 = n_5 = \dots$$
$$n_2 = n_4 = n_6 = \dots$$
$$Y_0 = Y_{n_2} = Y_{n_4} = \dots$$

$$Y_0 = \frac{X_+ (1-\alpha)^{n_2} (1-(1-\alpha)^{n_1}) + X_- (1-(1-\alpha)^{n_2})}{1-(1-\alpha)^{n_1 + n_2}}$$

$$Y_{n_1} = Y_{n_3} = Y_{n_5} = \dots$$

$$Y_{n_1} = \frac{X_- (1-\alpha)^{n_1} (1-(1-\alpha)^{n_2}) + X_+ (1-(1-\alpha)^{n_1})}{1-(1-\alpha)^{n_1 + n_2}}$$

Diese Werte weichen von dem im Idealfall zu erwartenden Sollwert, der sich am Ausgang des Filters einstellen müßte ab. Dieser beträgt:

$$Y_0 = Y_{n_1} = \frac{n_1 - n_2}{n_1 + n_2} \cdot \frac{X_+ - X_-}{2} + \frac{X_+ + X_-}{2}$$

Die Wahl der Parameter $n_1 + n_2$ und $\alpha$ erfolgt so, daß zur Erzielung einer bestimmten zeitlichen Auflösung die Abtastwerte ausreichend dicht hintereinander folgen müssen. Damit ist $n_1 + n_2$ festgelegt, das Verhältnis $n_1/n_2$ stellt sich in Abhängigkeit von dem Tastverhältnis des Eingangssignals ein. Aus dem Wert $\alpha$ $(n_1 + n_2)$ bestimmt sich das Einschwingverhalten bzw. Approximationsverhalten des Filters.

Hierbei kann $\alpha$ innerhalb eines bestimmten Wertebereichs gewählt werden und braucht nicht, wie dies bei den Koeffizienten von konventionellen Tiefpaßfiltern der Fall ist, nur einen bestimmten Wert anzunehmen.

Die Größe des Wertes $\alpha$ $(n_1 + n_2)$ kann nun so klein gewählt werden, daß der Fehler der sich ergebenden $Y_{n_i}$-Werte ausreichend klein gegenüber dem im Idealfall zu erwartenden Sollwert ist. Dies entspricht dem beim Tiefpaßfilter angestrebten Verhalten. Hier wird jedoch weiter der arithmetische Mittelwert

$$Y'_{n_1} = \frac{Y_0 + Y_{n_1}}{2}, \quad Y'_{n_2} = \frac{Y_{n_2} + Y_{n_1}}{2}$$

gebildet. Es ist

$$Y'_{n_1} = Y'_{n_2} = \frac{X_+ + X_-}{2} + \frac{X_+ - X_-}{2} \cdot \frac{((1-\alpha)^{n_2} - (1-\alpha)^{n_1})}{1-(1-\alpha)^{n_1 + n_2}}$$

Die Abweichung dieses Wertes gegenüber dem Idealwert ist nun erheblich geringer als die Abweichungen der Werte $Y_0$ bzw. $Y_{n_1}$.

Das erfindungsgemäße Filter läßt sich schaltungsmäßig wesentlich einfacher und mit einem geringeren Aufwand realisieren, als dies bei Tiefpaßfilterung üblicher Art für eine Mittelwertbildung beim Vorliegen von Signalen genannter Art möglich wäre. Zur gleitenden und arithmetischen Mittelwertbildung sind im wesentlichen lediglich Subtrahierer und Addierer notwendig.

Die Erfindung wird anhand der schematischen Zeichnung näher erläutert. Es zeigen:

Fig. 1       die Abtastzeitpunkte des erfindungsgemäßen digitalen Filters für das Eingangssignal;
Fig. 2       eine bevorzugte Ausführungsform für die schaltungsmäßige Realisierung des Filters und
Fig. 3       das Verhalten des erfindungsgemäßen Filters.

In Fig. 1 wird die Impulsfolge des Eingangssignals X über die Zeit t dargestellt. Diese Eingangsfunktion kann nur bestimmte Werte, z. B. $X_+ = +1$ und $X_- = -1$ annehmen. $t_1$ bis $t_n$ sind die Abtastzeitpunkte zwischen zwei Flanken; sie werden nach Vorliegen einer Flanke erneut gestaltet. $n_1$ bis $n_n$ stellen die Anzahl der Abtastwerte dar und dementsprechend werden generative Anfangs- bzw. Endwerte $Y_0$, $Y_{n_1}$, $Y_{n_2}$ ... usw. erhalten. Dabei ist $Y_0$ der Anfangswert von Y zum Zeitpunkt $t_0$ und z. B. $Y_{n_3}$ der Wert zum Zeitpunkt $t_{n_3}$.

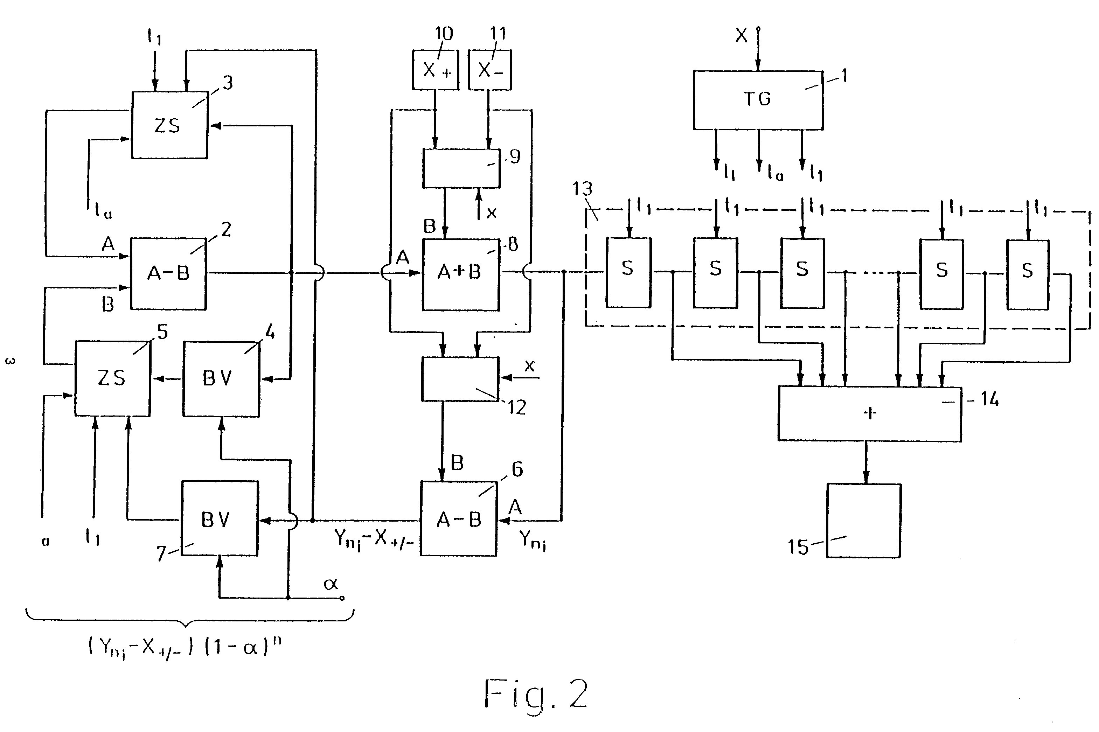

Fig. 2 zeigt eine mögliche Schaltungsanordnung zur Realisierung des erfindungsgemäßen Filters. Der Taktgenerator 1 erzeugt ein periodisches Abtastsignal $t_a$ derart, daß jeweils eine bestimmte Anzahl von Impulsen innerhalb einer Periodendauer des Eingangssignals anfällt. Die Anzahl der Abtastsignale $t_a$ bestimmt im Zusammenhang mit dem Faktor $\alpha$ das Einschwingverhalten des Filters und die Genauigkeit, mit der das Endsignal approximiert wird. Beim jeweils ersten Abtastsignal innerhalb eines Zyklus von X, d.h. wenn X von $X_-$ nach $X_+$ bzw. von $X_+$ nach $X_-$ wechselt, wird das Abtastsignal $t_1$ erzeugt, wie es in Fig. 1 gezeigt ist. Mit dem Impuls $t_1$ wird die Anordnung zur Ermittlung von $(Y_{n_{j-1}} - X_{+/-}) \cdot (1-\alpha)^n$ gestartet.

Der Faktor $\alpha$ wird als eine Potenz von 1/2 gewählt, so daß bei binärer Darstellung des Endsignals die Multiplikation mit $\alpha$ durch Bit-Verschiebung um k bit erfolgen kann. Die Multiplikation einer binären Zahl mit $(1-\alpha)$ kann damit durch Subtraktion des um k bit verschobenen Wertes vom ursprünglichen Wert erfolgen. Das Ausgangssignal des Subtrahierers 2 wird hierzu über den Zwischenspeicher 3 direkt und über den Bit-Verschieber 4 und den Zwischenspeicher 5 um k bit verschoben bei jedem Abtastimpuls $t_a$ an die beiden Eingänge des Subtrahierers 2 zurückgeführt, so daß nach jedem Abtastimpuls $t_a$ am Ausgang des Subtrahierers 2 der mit $(1-\alpha)$ multiplizierte vorhergehende Wert anliegt. Zu Beginn eines jeden Zyklus, d.h. bei $t_1$, wird der am Ausgang des Subtrahierers 6 anliegende Wert

$(Y_{n_{i-1}} - X_+)$ bzw. $(Y_{n_{i-1}} - X_1)$

in den Zwischenspeicher 3 bzw. über Bit-Verschieber 7 um k bit verschoben in den Zwischenspeicher 5 geladen. In Addierer 8 wird zu

$(Y_{n_{i-1}} - X_+) (1-\alpha)^n$ bzw.
$(Y_{n_{i-1}} - X_-) (1-\alpha)^n$

der Wert $X_+$ bzw. $X_-$ addiert. Über den Umschalter 9 werden, je nach Zustand des Signal X, aus den Speichern 10 bzw. 11 die Werte für $X_+$ bzw. $X_-$ entnommen und dem Addierer 8 zugeführt. Am Ausgang von 8 steht damit am Ende eines jedes Zyklus der Wert $Y_{n_i}$ zur Verfügung.

Im Subtrahierer 6 wird hiervon der Wert $X_-$ bzw. $X_+$ subtrahiert. Je nach Zustand von X wird über den Umschalter 12 der entsprechende Wert aus den Speichern 10 oder 11 entnommen. Am Ausgang des Subtrahierers 6 steht somit der Anfangswert von $(Y_{n_1} - X_+)$ bzw. $(Y_{n_1} - X_-)$ für den nächsten Zyklus zur Verfügung.

Andere Schaltungskonfigurationen, die den gleichen mathematischen Algorithmus bewirken, sind denkbar, z. B. Vertauschen der Reihenfolge von 4 und 5 bzw. 7 und 5, Zusammenfassen der Speicher 3 und 4, Mehrfachnutzung der Addierer bzw. Subtrahierer 2, 6 und 8.

Die Ausgangswerte des Addierers 8 werden bei Beginn eines neuen Zyklus in die erste Speicherzelle eines Schieberegisters 13 eingelesen, die zuvor eingelesenen Werte werden dabei jeweils um eine Speicherzelle weitergeschoben. Die Anzahl der Speicherzellen des Schieberegisters 13 entspricht der Anzahl der Signalwechsel von X, d.h. von $X_+$ nach $X_-$ bzw. von $X_-$ nach $X_+$, innerhalb einer Periodendauer des Eingangssignals X oder ist ein ganzzahliges Vielfaches hiervon. Die Ausgangswerte der einzelnen Speicherzellen werden zur Bildung des arithmetischen Mittelwertes einem Addierer 14 zugeführt, an dessen Ausgang eine Dividierstufe 15 vorgesehen sein kann.

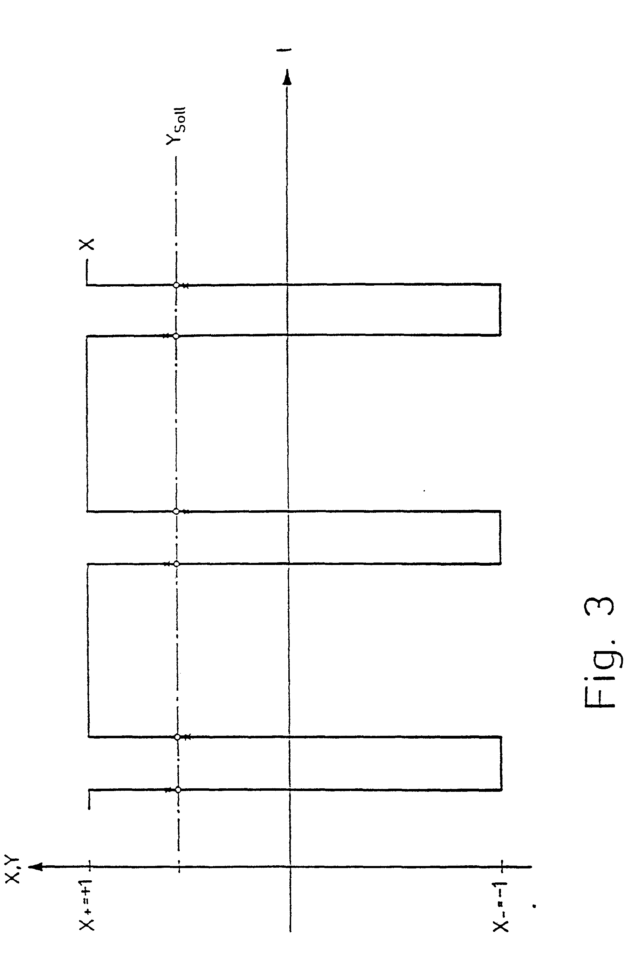

In Fig. 3 ist für einen bestimmten Verlauf von X der Verlauf von $Y_{n_1}$ bzw. Y gezeigt. $Y_{soll}$ bezeichnet den Sollwert des Mittelwertes von X. Die Werte von $Y_{n_i}$, die sich jeweils nach Abschluß eines Zyklus ergeben, sind durch ein Kreuz gekennzeichnet. Sie weichen vom Sollwert um einen bestimmten Betrag ab. Die Werte von Y am Ausgang des Addierers 14, die sich ebenfalls jeweils nach Abschluß eines Zyklus ergeben, sind durch Kreise gekennzeichnet. Sie weichen nur noch um einen sehr geringen Betrag vom Sollwert ab.

Der Vorteil dieses Filters gegenüber einem konventionellen digitalen Tiefpaßfilter liegt darin, daß bei üblichen Tiefpaßfiltern zur Erzielung gleicher Filtereigenschaften ein sehr hoher Filtergrad realisiert werden muß und die bei jenen Filtern notwendigen Multiplikationsstufen entfallen.

**Patentansprüche**

1. Schaltungsanordnung zur Mittelwertbildung eines aus Rechteckimpulsen bestehenden Eingangssignals, auf der Basis eines zeit- und wertdiskreten Filters, mit einem Taktgenerator (1), mit dem entsprechend einer Abtastrate fortlaufend Impulse ($t_a$) erzeugt werden, einem ersten Multiplizierer (4), der einem Eingang eines ersten Subtrahierers (2) vorgeschaltet ist, der zwei Signale voneinander subtrahiert, sowie einem ersten Addierer (8) und einem ersten Zwischenspeicher (3), *dadurch gekennzeichnet*, daß der Taktgenerator (1) zusätzlich bei jeder Flanke der Impulsfolge des Eingangssignals ein weiteres Signal ($t_1$) generiert, und daß das Ausgangssignal des ersten Subtrahierers (2) auf einer Schleife über den ersten Zwischenspeicher (3) an den einen Eingang und auf einer anderen Schleife über einen ersten als Bit-Verschieber ausgebildeten Multiplizierer (4) und einen zweiten Zwischenspeicher (5) an den anderen Eingang des ersten Subtrahierers (2) im Takte der vom Taktgenerator (1) erzeugten Impulse ($t_a$) geführt wird, daß zu dem ersten Addierer (8) der aktuelle Amplitudenwert des Eingangssignals und das Ausgangssignal des ersten Subtrahierers (2) geführt werden, daß ein zweiter Subtrahierer (6) vorgesehen ist, in dem vom Ausgangssignal des ersten Addierers (8) der jeweils andere Amplitudenwert des Eingangssignals abgezogen und beim Vorliegen einer Flanke beim Eingangssignal das Ausgangssignal des ersten Subtrahierers (6) in den ersten Zwischenspeicher (3) und über einen als Bit-Verschieber ausgebildeten zweiten Multiplizierer (7) in den zweiten Zwischenspeicher (5) anstelle des von dem Ausgang des ersten Subtrahierers (2) anliegenden Signals übernommen wird, daß das am Ausgang des ersten Addierers (8) anliegende Signal bei jeder Flanke der Impulsfolge des Eingangssignals in ein Schieberegister (13) mit den Speicherzellen (S) geführt wird, wobei die Anzahl der Speicherzellen (S) der Anzahl der Flanken der Impulsfolge innerhalb der Periodendauer oder einem Vielfachen davon entspricht und daß in einem zweiten Addierer (14) die Signalwerte der Speicherzellen (S) addiert werden und die Summe gegebenenfalls anschließend in einer Dividierschaltung (15) durch die Anzahl der Speicherzellen (S) dividiert wird, wobei dann das Ausgangssignal des zweiten Addierers (14) den arithmetischen Mittelwert der Signale in den Speicherzellen (S) des Schieberegisters (13) bildet.

2. Schaltungsanordnung nach Anspruch 1, *dadurch gekennzeichnet*, daß die arithmetische Mittelwertbildung über mindestens eine Periodendauer der Impulsfolge erfolgt.

3. Schaltungsanordnung nach einem der Ansprüche 1 bis 2, *dadurch gekennzeichnet*, daß zur Erzielung eines optimalen Einschwingverhaltens die Abtastrate des Taktgenerators (1) und die Anzahl der Bit-Verschiebungen in dem Bit-Verschiebern (4, 7) einander angepaßt werden.

## EP 0 215 810 B1

**Claims**

1. Circuit arrangement for averaging an input signal consisting of square-wave pulses, on the basis of a time- and amplitude-discrete filter, with a clock generator (1) by means of which pulses ($t_a$) are continuously generated according to a sampling rate, with a first multiplier (4) that is placed upstream of the input of a first subtractor (2) which subtracts two signals from each other, as well as with a first adder (8) and a first buffer (3), comprising: the clock generator (1) generating an additional signal ($t_1$) at each edge of the pulse train of the input signal; and carrying the output signal of the first subtractor (2), at the repetition rate of the pulses ($t_a$) generated by the clock generator (1), on one loop via the first buffer (3) to the one input, and on another loop, via the first multiplier (4) implemented as a bit shifter and a second buffer (5), to the other input of the first subtractor (2); carrying the actual amplitude value of the input signal and the output signal of the first subtractor (2) to the first adder (8); providing a second subtractor (6) in which the respective other amplitude value of the input signal is subtracted from the output signal of the first adder (8), and, when an edge of the input signal is available, the output signal of the first subtractor (6) is fed into the first buffer (3) and, via a second multiplier (7) that is implemented as a bit shifter, fed into the second buffer (5) instead of the signal applied at the output of the first subtractor (2); carrying the signal applied at the output of the first adder (8), at each edge of the pulse train of the input signal, into a shift register (13) with the storage locations (S), the number of storage locations (S) corresponding to the number of edges of the pulse train within its period or to a multiple thereof; and adding the signal values of the storage locations (S) in a second adder (14) and optionally dividing the sum in a divider stage (15) by the number of storage locations (S), the output signal of the second adder (14) forming the arithmetic mean of the signals in the storage locations (S) of the shift register (13).

2. Circuit arrangement as claimed in claim 1, wherein arithmetic averaging takes place during at least one period of the pulse train.

3. Circuit arrangement as claimed in any of the claims 1 to 2, wherein, in order to optimise the transient response, the sampling rate of the clock generator (1) and the number of bit shifts in the bit shifters (4, 7) are matched to each other.

**Revendications**

1. Dispositif de circuit pour la formation de la valeur moyenne d'un signal d'entrée constitué d'impulsions rectangulaires, sur la base d'un filtre discret en temps et en valeur, avec un générateur de synchronisation (1), grâce auquel sont obtenues, de façon continue, en correspondance avec un rythme d'exploration, les impulsions ($t_a$), avec un premier multiplicateur (4) branché en amont d'une entrée d'un premier soustracteur (2), qui soustrait l'un de l'autre deux signaux, ainsi qu'avec un premier totalisateur (8) et une première mémoire intermédiaire (3), dispositif de circuit caractérisé en ce que le générateur de synchronisation (1) engendre, en outre, pour chaque flanc de la succession d'impulsions du signal d'entrée, un autre signal ($t_1$), et que le signal de sortie du premier soustracteur (2) est amené à la cadence des impulsions ($t_a$) produites par le générateur de synchronisation (1) sur une boucle par l'intermédiaire de la première mémoire intermédiaire (3) à l'une des entrées du premier soustracteur (2), et sur une autre boucle par l'intermédiaire d'un premier multiplicateur (4) revêtant la forme d'un dispositif de décalage de chiffres binaires et d'une seconde mémoire intermédiaire (5) à l'autre entrée de ce premier soustracteur (2), la valeur actuelle d'amplitude du signal d'entrée et le signal de sortie du premier soustracteur (2) étant amenés au premier totalisateur (8), et un second soustracteur (6) étant prévu, dans lequel l'autre valeur respective d'amplitude du signal d'entrée, est extraite du signal de sortie du premier totalisateur (8), et lors de la présence d'un flanc pour le signal d'entrée, le signal de sortie du premier soustracteur (6) est pris en charge dans la première mémoire intermédiaire (3) et par l'intermédiaire d'un second multiplicateur (7) revêtant la forme d'un dispositif de décalage de chiffres binaires, est pris en charge dans la deuxième mémoire intermédiaire (5) au lieu du signal s'appliquant à partir de la sortie du premier soustracteur (2), tandis que le signal s'appliquant à la sortie du premier totalisateur (8) est amené pour chaque flanc de la succession d'impulsions du signal d'entrée dans un registre à décalage (13) avec les cellules de mémoire (S), le nombre de ces cellules de mémoire (S) correspondant au nombre des flancs de la succession d'impulsions à l'intérieur de la durée de la période ou bien d'un multiple de cette durée, et dans un second totalisateur (14) les valeurs des signaux des cellules de mémoire (S) sont totalisées et la somme est éventuellement divisée ensuite dans un circuit diviseur (15) par le nombre des cellules de mémoire (S), le signal de sortie du second totalisateur (14) constituant alors la valeur moyenne arithmétique des signaux dans les cellules de mémoire (S) du registre à décalage (13).

2. Dispositif de circuit selon la revendication 1, caractérisé en ce que la formation de la valeur moyenne arithmétique s'effectue sur au moins une durée de la période de la succession d'impulsions.

3. Dispositif de circuit selon une des revendications 1 à 2, caractérisé en ce que pour obtenir un comportement transitoire optimal, les taux d'exploration du générateur de synchronisation (1) et le nombre des décalages de chiffres binaires, dans les dispositifs de décalage de chiffres binaires (4, 7) sont adaptés les uns aux autres.

6

Fig. 1

EP 0 215 810 B1

Fig. 2

X,Y

X+ = +1

$Y_{Soll}$

X

X- = -1

I

Fig. 3